# EUROPEAN PATENT SPECIFICATION

(11) **EP 1 546 051 B1**
(45) Date of publication and mention of the grant of the patent: **12.07.2006**
(21) Application number: 03791842.2
(22) Date of filing: 27.08.2003
(51) Int. Cl.: C03C 3/089, C03B 37/02

(54) **LOW-TEMPERATURE, FLUORIDE FREE FIBER GLASS COMPOSITIONS AND PRODUCTS MADE USING SAME**
FLUORIDFREIE TIEFTEMPERATUR-FASERGLASZUSAMMENSETZUNG UND DAMIT HERGESTELLTE PRODUKTE
COMPOSITIONS DE FIBRE DE VERRE BASSE TEMPERATURE, SANS FLUORURE, ET PRODUITS OBTENUS A PARTIR DE CES COMPOSITIONS

(30) Priority: 27.08.2002 US 406315 P
(43) Date of publication of application: 29.06.2005
(73) Proprietor: PPG Industries Ohio, Inc., Cleveland, OH 44111 (US)
(72) Inventor: LI, Hong, Sewickley, PA 15143 (US); RICHARDS, Cheryl A., Monroeville, PA 15146 (US); COX, E. Jeffrey, Cherryville, NC 28021 (US)
(74) Representative: Sternagel, Fleischer, Godemeyer & Partner
(86) International application number: PCT/US2003/026825
(87) International publication number: WO 2004/020355

(56) References cited:
- EP-A- 0 186 077
- FR-A- 2 692 248
- US-A- 2 571 074
- US-A- 4 771 019

## Description

### Cross-Reference to Related Application

This application claims the benefits of United States Provisional Application No. 60/406,315 entitled "Low-Temperature, Fluoride Free Fiber Glass Compositions and Products Made Using Same" filed August 27, 2002, which is herein incorporated by reference in its entirety.

### BACKGROUND OF THE INVENTION

### 2. Field of the Invention

This invention relates to low temperature; fluoride free glass fiber compositions, and products made using such glass fibers, and in particular, to fluoride-free boron-containing E-glass fiber compositions having the temperature properties of a fluoride and boron containing E-glass fiber composition, and to products using such glass fibers, e.g. glass fiber reinforced plastic composites.

### 3. Discussion of the Technical Problem

In the art of producing glass fibers or fiber glass, it is recognized that fluoride is a flux during batch melting and aids in lowering melt viscosity of the glass thereby lowering the fiber-forming temperature. Although fluoride aids in the melting of glass batch, there are drawbacks. More particularly, fluoride is volatile at the glass melting and fining temperatures, and emission control equipment is sometimes used to prevent fluoride from being discharged into the environment.

It has been recognized that E-glass compositions can be made without fluoride and with less than 3.0 weight percent boron ("weight percent"). EP Patent Application No. 0.832 046 published April 5, 2000, titled "BORON-FREE GLASS FIBERS" discloses a boron free glass composition having fluoride in the range of 0 to 0.5 weight percent. The examples of the EP Application have a forming temperature at 1000 poise ranging from 1259°C to 1266°C and a forming window ranging from 72°C to 96°C. PCT Application No. WO 01/32576 A1 published May 10, 2001, titled "GLASS YARNS, COMPOSITE THEREOF, METHOD FOR MAKING SAME AND REINFORCEING GLASS COMPOSITION", discloses a fiber glass composition having less than 1 weight percent fluoride and 0.5 to 3 weight percent boron. The examples of the PCT Application have a forming temperature at 1000 poise ranging from 1200°C to 1350°C with forming window ranging from as low as 5°C to 75°C with most of the compositions have forming window around 40°C. Although the glass compositions of the EP and PCT Applications are acceptable for their intended purpose there are limitations. More particularly, the glasses have a high forming temperature, e.g. above 1195°C. Glass compositions that have high forming temperatures require greater energy usage and result in shorter bushing life. The small forming window, e.g. less than 50°C, increases the tendency of the glass fibers to devitrify causing fiber breaks.

Therefore, it can be seen that using fluoride as a melting aid has drawbacks, and fluoride-free boron-containing fiber glass compositions presently available have drawbacks as well. It would be advantageous to provide fluoride-free, boron-containing fiber glass compositions that have thermal properties, e.g. forming temperatures below 1190°C and a forming window greater than 50°C, similar to prior art fluoride and boron-containing fiber glass compositions.

### SUMMARY OF THE INVENTION

This invention relates to fluoride or fluorine-free glass compositions. As appreciated by those skilled in the art, fluorine is present in the glass as a fluoride, e.g. calcium fluoride and/or sodium fluoride. Since fluorine is present in the glass as a fluoride, all forms of fluorine in the glass will be referred to as "fluoride". Analytically, the concentration of fluoride in the glass is conventionally reported as F2. The source of deliberate additions of fluoride to glass is usually a fluorspar component in the batch mixture. The concentration of fluoride (F2) in commercial fiber glass is typically in the range of 0.5 to 0.7 weight percent when fluoride is deliberately included as a fluxing agent. Fluoride in low weight percent, e.g. less than 0.1 weight percent and typically between 0.02 and 0.06 weight percent is also present in the glass as an impurity from one or more of the other batch materials. In the practice of this invention, the amount of fluoride present in the glass is limited to impurity levels, i.e., less than about 0.1 weight percent, even if deliberately added. Therefore, for the purposes of this invention, "fluoride free" means less than about 0.1 weight percent fluoride.

In the present invention the fluoride-free, boron-containing glass has a forming temperature no greater than 1190°C, and in some embodiments the forming temperature is no greater than 1185°C. The glasses of the present invention are also characterized by a forming window of at lease 50°C. "Forming temperature" is the temperature of the glass at which the viscosity of the glass is 1000 poise (commonly expressed as the "log 3 viscosity"). Liquidus temperature is the temperature at which minute solid phase (crystals) is in equilibrium with the liquid phase of the glass melt. The forming window is the difference between the forming temperature and the liquidus temperature. Forming window is a common measure of the crystallization potential of a given melt composition. The smaller the difference between the forming temperature and the liquidus temperature, the greater is the crystallization potential.

In a non-limiting embodiment of the invention, a glass composition includes the following ingredients in the following weight percents ("weight percent")

| | |
|---|---|
| SiO₂ | 50 - 54 percent |
| Al₂O₃ | 12-15 percent |
| CaO | 22-25 percent. |
| MgO | 1-4 percent |
| B₂O₃ | 5-8 percent |
| (Na₂O + K₂O) | less than 2 percent |
| Fe₂O₃ | 0.1 - 0.5 percent |
| F₂ | less than 0.1 percent |

the glass having a forming window of at least 50°C and a forming temperature no greater than 1190°C (or no greater than 1185°C).

In another non-limiting embodiment, the glass may include:

| | |
|---|---|
| SiO₂ | 50 to 54 weight percent |
| Al₂O₃ | 12 to 15 weight percent |
| CaO | 22 to 25 weight percent |
| MgO | 1 to 4 weight percent |
| SrO | 0 to 3 weight percent |
| (MgO + SrO) | 1 to 4 weight percent |
| B₂O₃ | 5 to 8 weight percent |
| F₂ | less than 0.1 weight percent, |

wherein the glass has a forming window of at least 50°C and a forming temperature no greater than 1190°C (or no greater than 1185°C).

The glass compositions of certain non-limiting embodiments of the invention have the following relationship of the ingredients:

The sum of the weight percent of CaO + MgO + SrO ("RO") may be 24.75 to 26.25 percent, and in some embodiments 25 to 26 percent.

The ratio of the weight percent of RO/(SiO₂+Al₂O₃) may be 0.30 to 0.45, and in some embodiments 0.35 to 0.40.

The ratio of the weight percent of (R₂O + RO + B₂O₃)/(SiO₂ + Al₂O₃) may be 0.40 to 0.55, and in some embodiments 0.44 to 0.50. "R₂O" is the sum of the weight percent of Na₂O + Li₂O + K₂O.

In another non-limiting embodiment of the invention the fluoride-free glass composition may comprise the following constituents ("weight percent"):

| | |
|---|---|
| SiO₂ | 52.86 to 54.33 weight percent |
| B₂O₃ | 5.15 to 6.05 weight percent |
| Al₂O₃ | 13.44 to 14.14 weight percent |
| CaO | 23.42 to 24.16 weight percent |
| MgO | 1.17 to 1.5 weight percent |
| SrO | 0 to 0.15 weight percent |
| MgO + SrO | 1.40 to 1.65 weight percent |

Optionally, the glass composition above may additionally include:

| | |
|---|---|
| Total iron (expressed as Fe2O3) | 0.29 to 0.37 weight percent |
| SO₃ | greater than 0 weight percent, |
| K₂O | 0.09 to 0.1 weight percent |
| TiO₂ | 0.5 to 0.6 weight percent |
| Na₂O | 0.4 to 0.9 weight percent |
| ZrO₂ | less than 0.1 weight percent |

The glass compositions of the invention may be used to make continuous glass fiber strand or chopped fiber glass reinforcements.

### DISCUSSION OF THE INVENTIION

All numbers expressing dimensions, physical characteristics, and so forth, used in the specification and claims are to be understood as being modified in all instances by the term "about". Accordingly, unless indicated to the contrary, the numerical values set forth in the following specification and claims can vary depending upon the desired properties sought to be obtained by the present invention. At the very least, and not as an attempt to limit the application of the doctrine of equivalents to the scope of the claims, each numerical parameter should at least be construed in light of the number of reported significant digits and by applying ordinary rounding techniques. Moreover, all ranges disclosed herein are to be understood to encompass any and all subranges subsumed therein. For example, a stated range of "1 to 10" should be considered to include any and all subranges between (and inclusive of) the minimum value of 1 and the maximum value of 10; that is, all subranges beginning with a minimum value of 1 or more and ending with a maximum value of 10 or less, e.g., 5.5 to 10.

As used in the following discussion regarding the high temperature properties of the glass, the terms "melting temperature" (or "T_{M}" mean the temperature of the glass at which the viscosity of the glass is log1.7 or 50 poise. "T_{F}" means the forming temperature as defined above. "T_{L}" means the "liquidus temperature" as defined above. The forming window, i.e., the difference between T_{F} and T_{L}, may also be referred to herein as "ΔT." In the commercial production of glass fiber, a minimum AT of least 50°C (90°F) is considered desirable in order to prevent devitrification of the molten glass during a glass fiber forming operation, in particular in the bushing area.

The fiber glass compositions of the invention have thermal properties similar to the thermal properties of fluoride and boron-containing glasses, e.g. melting temperatures below 1420°C; forming temperatures no greater than 1190°C, and a forming window not less than 50°C.

As is known to those of skill in the art, additional optional ingredients may be added to glass composition to alter certain properties of the glass without departing from the practice of the present invention. Other materials may be present in the batch materials as impurities. These ingredients include but are not limited to FeO and/or Fe₂O₃ (collectively referred to as "iron"), Na₂O, Li₂O, and K₂O. Iron may be present in amounts of 0.005 to 1.5 weight percent, preferably 0.01 to 1 weight. percent and more preferably 0.05 to 0.8 weight percent. Na₂O, Li₂O or K₂O may be present in amounts of 0 to 2 weight percent, or 0 to 1.5 weight percent, or 0 to 1 weight percent. Further, sulfate (or SO₃) may be present as a melting and fining aid in amounts of greater than 0 weight percent.

Boron and fluoride are conventionally added to the glass batch to lower the melting temperature of the batch. As the weight percent of the boron in the batch increases while keeping the other ingredients in the batch relatively constant in their proportions to each other, the melting temperature of the batch decreases. The drawback with using boron is that it raises environmental issues and is generally only used when specified as an ingredient in the glass composition, e.g. in E-glass compositions. E-glass compositions are discussed below. As the weight percent of fluoride in the batch increases while keeping the other ingredients in the batch relatively constant in their proportions to each other; the melting temperature of the batch decreases. A drawback with using fluoride is that it raises environmental issues and is usually added as a batch ingredient to reduce the melting temperature of the batch and to reduce the viscosity of the glass.

Varying the ingredients of the batch materials without additives, such as boron and fluoride, can also reduce the viscosity of the glass. More particularly, it is known that pure silica is the highest melting glass former. A pure silica melt does not have a well defined melting point, but gradually solidifies and forms a glass as it cools to room temperature and its viscosity drops from greater than log 4 (10,000) poise at 2500°C (4532°F). Pure calcia, magnesia and alumina melts are known to have very low viscosities of 0.5 to 2 poise at their respective melting points. These materials do not solidify into a glass but rather crystallize instantly at their sharply defined melting point.

Based on these material properties, it can be inferred that as SiO₂, which is the largest oxide component of the glass composition in terms of weight percent, is reduced in a given composition of this type, the melt viscosity and the resulting log 3 forming temperature drops. If CaO, which is the second largest component of the glass composition in terms of weight percent, or MgO and /or SrO is increased in such a composition, the effect of the sum of the weight percent of CaO + MgO + SrO defined as RO on the glass properties will be twofold. It will not only increase the fluidity of the resulting melt (i.e. decrease its viscosity) and it will increase the crystallizability of the resulting melt (i.e. increase its liquidus temperature), having the effect of reducing ΔT.

For example, increasing the ratio of the weight percent of RO to the weight percent of the sum of SiO₂ and Al₂O₃ (RO/(SiO₂ + Al₂O₃)) while keeping proportions of the other ingredients in the batch constant decreases the melting temperature and visa versa. As can be appreciated by one skilled in the art of making glass fibers, the ratio of RO/(SiO₂ + Al₂O₃) is controlled to lower melt viscosity or melting and forming temperature; however, the lowering of the melt viscosity has to be realized without significantly increasing liquidus temperature. As discussed above, to ensure a safe fiber forming process, the fiber forming window, i.e., (T_{F} - T_{L}) should be maintained at 50°C (90°F) or greater. In some embodiments of the invention, the ratio of RO/(SiO₂ + Al₂O₃) of the glass compositions ranges from 0.30 to 0.45, and in other embodiments from 0.35 to 0.40.

In addition to changing the ratio RO/(SiO₂ + Al₂O₃) to provide an adequate fiber forming window and a low forming temperature, i.e. less than 1190°C and preferably less than 1185°C, in the instance when the glass composition contains boron, e.g. in the case of E-glass compositions, and alkalis, e.g. but not limiting to the invention Na₂O, Li₂O, and K₂O further tuning of the thermal properties can be realized by changing the ratio of the sum of the weight percent of Na₂O, Li₂O, K₂O, RO and B₂O₃ to the sum of the weight percent of SiO₂ and Al₂O₃ ((R₂O + RO + B₂O₃)/(SiO₂ + Al₂O₃) where R₂O = Na₂O + Li₂O + K₂O). The (R₂O + RO + B₂O₃) /(SiO₂ + Al₂O₃) ratio is another ratio used to characterize a given melt. In some embodiments of invention, the (R₂O + RO + B₂O₃) /(SiO₂ + Al₂O₃) ratio of the glass composition may range from 0.40 to 0.55, and in other embodiments it may range from 0.44 to 0.48.

Lower Al₂O₃ levels will typically result in lower crystallization potential, and a higher Al₂O₃ level will typically result in a higher crystallization potential for a given melt. With respect to Al₂O₃/SiO₂ ratio, a decreasing ratio would be accompanied by a reduction in the crystallization potential of the melt.

Each of these compositional features of the glass reflect the relative balance between the fluidity (i.e. viscosity) of the glass melt and its crystallization potential, as will be discussed later in more detail. The physical melt properties of interest are the melting temperature, forming temperature and the liquidus temperature since one non-limiting embodiment of the present invention is to provide a fluoride free, boron containing glass composition having a forming temperature and a ΔT similar to a fluoride and boron-containing electronic E-glass so that the compositions are interchangeable without making major changes in the fiber forming process.

The E-glass composition is defined in ASTM Designation: D 578 - 00 entitled Standard Specification for Glass Fiber Strands as a family of glasses composed primarily of the oxides of calcium, aluminum, and silicon. The following chemical composition of E-glass applies to glass fiber products for electronic applications such as printed circuit boards:

| Component | % by Weight |
|---|---|
| B₂O₃ | 5 to 10 |
| CaO | 16 to 25 |
| Al₂O₃ | 12 to 16 |
| SiO₂ | 52 to 56 |
| MgO | 0 to 5 |
| Na₂O and K₂O | 0 to 2 |
| TiO₂ | 0 to 0.8 |
| Total FeO and Fe₂O₃ | 0.05 to 0.4 |
| Fluoride (F₂) | 0 to 1.0. |

Samples 1 to 10 were made as follows. Batches, approximately 1000 grams per formulation, were prepared using commercial ingredients. Table 1 shows the composition of the batch materials for Samples 1 to 10. Fluorspar was added to the batch for Samples 6 to 9 to provide the fluoride and quicklime was added to the batch for Samples 7 and 8 to provide CaO.

The ingredients were thoroughly mixed and charged into a platinum crucible. The batch materials were heated to, and maintained for four hours at, a temperature of 1450°C to melt the materials and ensure melt homogeneity. After melting, the molten glass was poured onto a stainless steel plate and two buttons were cut-from the hot glass for subsequent testing discussed below. Each button had a 2 inches (5.08 centimeter) diameter.

The weight percent of the ingredients in the glass samples except for boron was measured using the x-ray fluorescence (XFR) method, and the weight percent of boron was measured using the neutron absorption method. The measurements presented in the following discussion are the average of two measurements. Table 2 lists the weight percent of the ingredients in the glass buttons. Samples 1 to 5 and 10 had impurity amounts of fluoride, more particularly, fluoride in the range of 0.02 to 0.08 weight percent; Samples 6 through 9 had fluoride in amounts in the range of 0.11 to 0.27 weight percent, and are not examples of the present invention.

A piece of glass weighing about 70 grams of each sample composition was used to determine liquidus temperature, and a piece of glass weighing about 500 grams of each sample composition was used to determine melt viscosity as a function of temperature. The forming temperature, i.e. the glass temperature at a viscosity of 1000 poise, was determined by ASTM method C965-81, and the liquidus temperature by ASTM method C829-81. Table 3 summarizes the high-temperature properties, liquidus (T_{L}), forming (T_{F}), forming window (T_{F-L}), and melting (T_{M}) of Samples 1 to 10.

The results of the measurements demonstrate the invention achieved low-melting fiber glass compositions having no more than trace amounts of fluoride, e.g., below 0.1 weight percent, and boron in amounts in the range of about 5 to 8 weight percent without adversely impacting the fiber forming window. At least 5 weight percent B₂O₃ is required by the specification for electronic E-glass, minimizing boron content within that range may be advantageous in some cases, so certain embodiments of the invention employ B₂O₃ in amounts of 5 to about 7 weight percent or 5 to about 6 weight percent.

Table 4 shows the major constituents and ratios of the constituents of Samples 1 to 10. Samples 1 to 5 and 10 incorporate features of the invention.

The glass made in accordance to the teachings of the invention may be used to make any type of product that uses glass. For example, but not limiting thereto, glass fibers made using the glass compositions of the invention may be used to make woven glass fiber cloth and printed circuit boards having woven fiber glass cloth. The art of making glass fibers, woven fiber glass cloth and printed circuit boards using woven fiber glass cloth are well known in the art and no further discussion is deemed necessary.

**Table 1. Batch Formulations of Samples 1 to 10**

| **Batch Formulation** | **Example 1** | **Example 2** | **Example 3** | **Example 4** | **Example 5** |
|---|---|---|---|---|---|
| CLAY | 270.20 | 265.20 | 274.80 | 265.20 | 269.50 |
| COLEMANITE | 95.60 | 80.60 | 70.70 | 37.90 | 37.10 |
| ULEXITE | 38.20 | 38.20 | 38.20 | 80.20 | 86.20 |
| FLUORSPAR | 0.00 | 0.00 | 0.00 | 0.00 | 0.00 |
| ROUGE | 0.60 | 0.60 | 0.60 | 0.60 | 0.70 |
| LIMESTONE | 265.60 | 258.90 | 267.40 | 265.60 | 260.50 |
| DOLOMITE | 13.10 | 18.00 | 18.90 | 18.00 | 18.00 |
| SILICA | 281.10 | 281.70 | 285.40 | 281.70 | 274.30 |
| SODIUM SULFATE | 2.00 | 2.00 | 2.00 | 2.00 | 0.90 |
| SODA ASH | 0.00 | 0.00 | 0.00 | 0.00 | 3.70 |
| RUTILE | 0.00 | 0.00 | 0.00 | 0.00 | 0.00 |
| QUICKLIME | 0.00 | 0.00 | 0.00 | 0.00 | 0.00 |
| Total (g) | 966.40 | 945.20 | 958.00 | 951.20 | 950.90 |

| **Batch Formulation** | **Example 6** | **Example 7** | **Example 8** | **Example 9** | **Example 10** |
|---|---|---|---|---|---|
| CLAY | 268.90 | 287.68 | 283.54 | 268.60 | 282.60 |
| COLEMANITE | 29.45 | 27.13 | 28.27 | 25.63 | 23.80 |
| ULEXITE | 92.60 | 110.72 | 110.96 | 95.80 | 101.70 |
| FLUORSPAR | 4.85 | 5.35 | 2.675 | 7.28 | 0.00 |
| ROUGE | 0.65 | 0.85 | 0.98 | 0.63 | 0.70 |
| LIMESTONE | 262.65 | 177.37 | 176.98 | 263.73 | 288.20 |
| DOLOMITE | 12.20 | 14.40 | 17.85 | 9.30 | 12.50 |
| SILICA | 275.35 | 311.80 | 314.20 | 275.88 | 286.80 |
| SODIUM SULFATE | 0.90 | 0.78 | 0.79 | 0.90 | 0.90 |
| SODA ASH | 3.40 | 2.85 | 2.78 | 3.25 | 2.80. |
| RUTILE | 0.00 | 0.00 | 0.00 | 0.00 | 0.00 |
| QUICKLIME | 0.00 | 61.07 | 61.03 | 0.00 | 0.00 |
| Total (g) | 950.95 | 1000.00 | 1000.05 | 950.98 | 1000.00 |

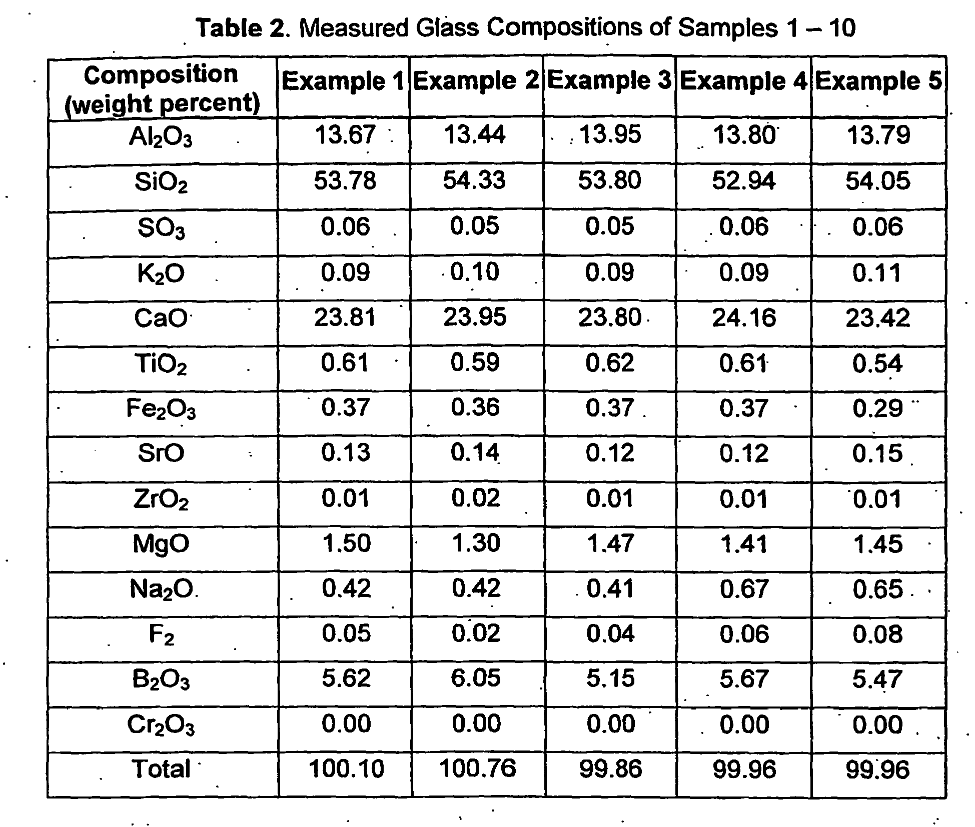

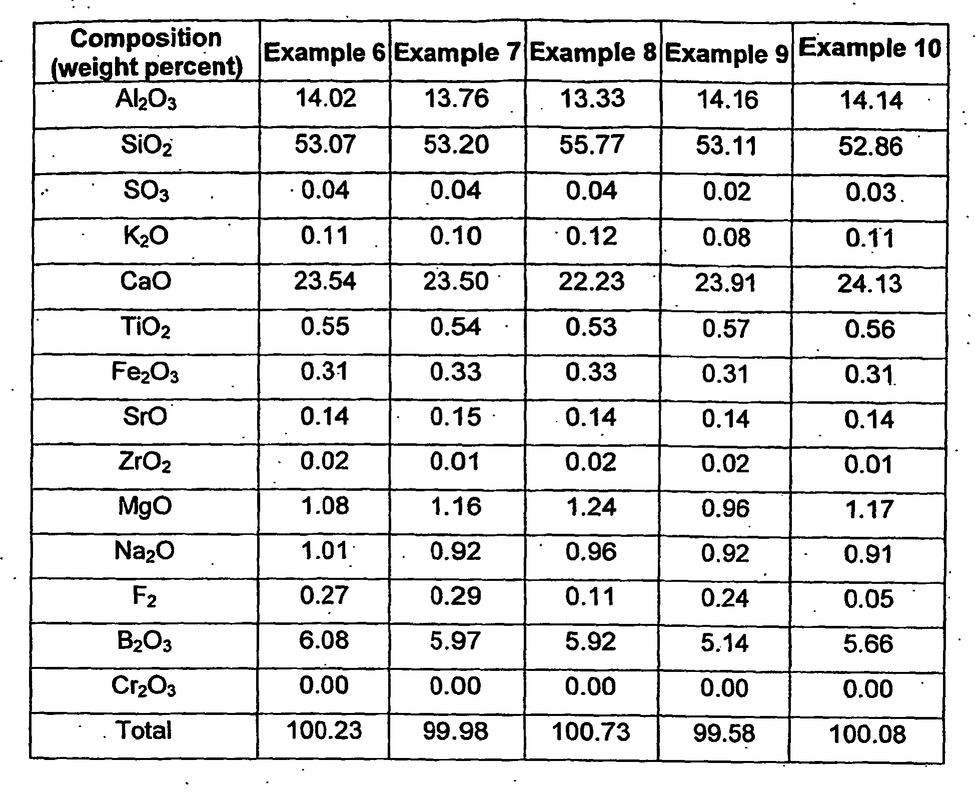

**Table 3. Fiber Processing Properties of Samples 1 to 10**

| **Glass ID** | **Example 1** | **Example 2** | **Example 3** | **Example 4** | **Example 5** |
|---|---|---|---|---|---|
| Liquidus, T_{L} (°C) | 1097 | 1101 | 1119 | 1105 | 1102 |
| Forming, T_{F} (°C) | 1163 | 1171 | 1180 | 1169 | 1166 |
| Window, T_{F}-T_{L} (°C) | 66. | 70 | 61 | 64 | 64 |
| Melting, TM (°C) | 1397 | 1410 | 1419 | 1409 | 1406 |

| **Glass ID** | **Example 6** | **Example 7** | **Example 8** | **Example 9** | **Example 10** |
|---|---|---|---|---|---|
| Liquidus, T_{L} (°C) | 1092 | 1110 | 1099 | 1115 | 1110 |
| Forming, T_{F} (°C) | 1156 | 1161 | 1163 | 1169 | 1163 |
| Window, T_{F}-T_{L} (°C) | 64 | 61 | 64 | 54 | 53 |
| Melting, T_{M} (°C) | 1396 | 1405 | 1408 | 1404 | 1399 |

**Table 4. Corresponding Ratios of Major Glass Components of Samples 1 to 10**

| **Major Constituents and Ratios** | **Example 1** | **Example 2** | **Example 3** | **Example 4** | **Example 5.** |
|---|---|---|---|---|---|
| RO | 25.43 | 25.38 | 25.38 | 25.68 | 25.02 |
| R2O | 0.51 | 0.52 | 0.50 | 0.76 | 0.76 |
| RO/(Al₂O₃+SiO₂) | 0.38 | 0.37 | 0.37 | 0.38 | 0.37 |
| Al₂O₃/SIO₂ | 0.25 | 0.25 | 0.26 | 0.26 | 0.26 |
| (B₂O₃+RO+R2O)/(Al₂O₃+SiO₂) | 0.47 | 0.47 | 0.46 | 0.48 | 0.46 |

| **Major Constituents and Ratios** | **Example 6** | **Example 7** | **Example 8** | **Example 9** | **Example 10** |
|---|---|---|---|---|---|
| RO | 24.75 | 24.81 | 23.61 | 25.01 | 25.44 |
| R2O | 1.12 | 1.02 | 1.08 | 1.00 | 1.02 |
| RO/(Al₂O₃+SiO₂) | 0.37 | 0.37 | 0.34 | 0.37 | 0.38 |
| Al₂O₃/SiO₂ | 0.26 | 0.26 | 0.24 | 0.27 | 0.27 |
| (B₂O₃+RO+RO2)/(Al₂O₃+SiO₂) | 0.48 | 0.47 | 0.44 | 0.46 | 0.48 |

It will be appreciated by those skilled in the art that changes can be made to the embodiments of the invention described above without departing from the broad inventive concept of the invention. Based on the description of the embodiments of the invention, it can be appreciated that this invention is not limited to the particular embodiments disclosed, but it is intended to cover modifications that are within the spirit and scope of the invention, as defined by the appended claims.

## Claims

1. A glass composition for fiber forming comprising, in percent by weight of total composition:
| | |
|---|---|
| SiO₂ | 50-54 percent |
| Al₂O₃ | 12-15 percent |
| CaO | 22-25 percent |
| MgO | 1-4 percent |
| B₂O₃ | 5-8 percent |
| Na₂O + K₂O | less than 2 percent |
| Fe₂O₃ | 0.1- 0.5 percent |
| F₂ | less than 0.1 percent |
the glass having a forming window of at least 50°C and a forming temperature no greater than 1190°C.

2. The glass composition according to claim 1, wherein the B₂O₃ content is 5 to 6 weight percent.

3. The glass composition according to claim further including SrO, wherein MgO + SrO is 1 to 4 weight percent.

4. The glass composition according to claim 3 wherein MgO + SrO is from 1 to 3 weight percent.

5. The glass composition according to claim 1 wherein the constituents have the following relationship and the following values:

6. The glass composition according to claim 1 wherein the constituents have the following values:
| | |
|---|---|
| (R₂O+RO+B₂O₃)/(SiO₂+Al₂O₃) | from 0.45 to 0.50 |
where R2O = weight percent of NaO₂ + Li₂O + K₂O, when present in glass, and RO = CaO+MgO+SrO.

7. The glass composition according to claim 6 wherein the constituents are in the following weight percent:
| | |
|---|---|
| SiO₂ | 52 to 54 weight percent |
| Al₂O₃ | 13 to 15 weight percent |
| CaO | 23 to 25 weight percent |
| MgO | 1 to 3 weight percent |
| SrO | 0 to 3 weight percent |
| MgO + SrO | 1 to 3 weight percent |

8. The glass composition according to claim 7, further including:
| | |
|---|---|
| total iron | 0.05 to 0.8 weight percent |
| SO₃ | greater than 0 weight percent. |

9. The glass composition according to claim 4, wherein the constituents comprise:
| | |
|---|---|
| SiO₂ | 52.86 to 54.33 weight percent |
| B₂O₃ | 5.15 to 6.05 weight percent |
| Al₂O₃ | 13.44 to 14.14 weight percent |
| CaO | 23.42 to 24.16 weight percent |
| MgO | 1.17 to 1.5 weight percent |
| SrO | 0.12 to 0.15 weight percent |
| MgO + SrO | 1.29 to 1.65 weight percent |

10. The glass composition according to claim 9 additionally comprising:
| | |
|---|---|
| Total iron | 0.29 to 0.37 weight percent |
| SO₃ | greater than 0 weight percent. |
| K₂O | 0.09 to 0.11 weight percent |
| TiO₂ | 0.54 to 0.62 weight percent |
| Na₂O | 0.41. to 0.91 weight percent |
| ZrO₂ | less than 0.1 weight percent |

11. The glass composition according to claim 10, wherein the constituents have the following values:
| | |
|---|---|
| Al₂O₃/SiO₂ | from 0.25 to 0.27 |
| RO = CaO+ MgO-SrO | from 25.02 to 25.68 |
| RO/(SiO₂+Al₂O₃) | from 0.37 to 0.38 |
| (R₂O +RO +B₂O₃)/(SiO₂+Al₂O₃) | from 0.46 to 0.48 |
wherein R₂O = weight percent of Na₂O + Li₂O + K₂O

12. The glass composition according to claim 1, wherein the forming temperature is no more than 1185°C.

13. A woven fiber glass cloth wherein at least one of the glass fiber has the composition of claim 1.

14. A printed circuit board comprising a woven fiber glass cloth wherein at least one of the glass fibers has the composition of claim 1.

## Patentansprüche

1. Eine Glaszusammensetzung zur Faserbildung, enthaltend in Gewichtsprozent der Gesamtzusammensetzung:
| | |
|---|---|
| SiO₂ | 50 - 54% |
| Al₂O₃ | 12 - 150% |
| CaO | 22 - 25% |
| MgO | 1 - 4% |
| B₂O₃ | 5 - 8% |
| Na₂O + K₂O | weniger als 2% |
| Fe₂O₃ | 0,1 - 0,5% |
| F₂ | weniger als 0,1%, |
wobei das Glas ein Formgebungsintervall von wenigstens 50°C und eine Formgebungstemperatur von nicht mehr als 1190°C aufweist.

2. Glaszusammensetzung nach Anspruch 1, worin der B₂O₃-Gehalt 5 bis 6 Gew.-% beträgt.

3. Glaszusammensetzung nach Anspruch 1, die zusätzlich SrO enthält, worin MgO + SrO 1 bis 4 Gew.-% beträgt.

4. Glaszusammensetzung nach Anspruch 3, worin MgO + SrO 1 bis 3 Gew.-% beträgt.

5. Glaszusammensetzung nach Anspruch 1, wobei die Bestandteile die folgende Beziehung und die folgenden Werte aufweisen:
| | |
|---|---|
| RO = CaO + MgO + SrO | |
| RO/(SiO₂ + Al₂O₃) | 0,30 bis 0,45. |

6. Glaszusammensetzung nach Anspruch 1, wobei die Bestandteile die folgenden Werte aufweisen:
| | |
|---|---|
| (R₂O + RO + B₂O₃)/(SiO₂ + Al₂O₃) | 0,45 bis 0,50. |
worin R₂O = Gewichtsprozent von Na₂O + Li₂O + K₂O, falls im Glas vorhanden, und RO = CaO + MgO + SrO.

7. Glaszusammensetzung nach Anspruch 5, wobei die Bestandteile die folgenden Gewichtsprozentanteile haben:
| | |
|---|---|
| SiO₂ | 52 bis 54 Gew.-% |
| Al₂O₃ | 13 bis 15 Gew.-% |
| CaO | 23 bis 25 Gew.-% |
| MgO | 1 bis 3 Gew.-% |
| SrO | 0 bis 3 Gew.-% |
| MgO + SrO | 1 bis 3 Gew.-%. |

8. Glaszusammensetzung nach Anspruch 7, die weiterhin enthält:
| | |
|---|---|
| Gesamteisen | 0,05 bis 0,8 Gew.-% |
| SO₃ | mehr als 0 Gew.-%. |

9. Glaszusammensetzung nach Anspruch 4, wobei die Bestandteile umfassen:
| | |
|---|---|
| SiO₂ | 52,86 bis 54,33 Gew.-% |
| B₂O₃ | 5,15 bis 6,05 Gew.-% |
| Al₂O₃ | 13,44 bis 14,14 Gew.-% |
| CaO | 23,42 bis 24,16 Gew.-% |
| MgO | 1,17 bis 1,5 Gew.-% |
| SrO | 0,12 bis 0,15 Gew.-% |
| MgO + SrO | 1,29 bis 1,65 Gew.-%. |

10. Glaszusammensetzung nach Anspruch 9, die zusätzlich enthält:
| | |
|---|---|
| Gesamteisen | 0,29 bis 0,37 Gew.-% |
| SO₃ | mehr als 0 Gew.-% |
| K₂O | 0,09 bis 0,11 Gew.-% |
| TiO₂ | 0,54 bis 0,62 Gew.-% |
| Na₂O | 0,41 bis 0,91 Gew.-% |
| ZrO₂ | weniger als 0,1 Gew.-%. |

11. Glaszusammensetzung nach Anspruch 10, wobei die Bestandteile die folgenden Werte aufweisen:
| | |
|---|---|
| Al₂O₃/SiO₂ | 0,25 bis 0.27 |
| RO = CaO+MgO+SrO | 25,02 bis 25,68 |
| RO/(SiO₂ + Al₂O₃) | 0,37 bis 0,38 |
| (R₂O + RO + B₂O₃)/(SiO₂ + Al₂O₃) | 0,46 bis 0,48, |
worin R₂O = Gewichtsprozent von Na₂O + Li₂O + K₂O.

12. Glaszusammensetzung nach Anspruch 1, worin die Formgebungstemperatur nicht mehr als 1185°C beträgt.

13. Gewebtes Glasfasertuch, worin wenigstens eine der Glasfasern die Zusammensetzung nach Anspruch 1 aufweist.

14. Leiterplatte, enthaltend ein gewebtes Glasfasertuch, worin wenigstens eine der Glasfasern die Zusammensetzung nach Anspruch 1 aufweist.

## Revendications

1. Composition de verre pour la formation de fibres comprenant, en % en poids de la composition totale :
| | |
|---|---|
| SiO₂ | 50-54 % |
| Al₂O₃ | 12-15 % |
| CaO | 22-25 % |
| MgO | 1-4 % |
| B₂O₃ | 5-8 % |
| Na₂O + K₂O | moins de 2% |
| Fe₂O₃ | 0,1-0,5 % |
| F₂ | moins de 0,1 %, |
le verre ayant une fenêtre de formation d'au moins 50°C et une température de formation de pas plus de 1190°C.

2. Composition de verre suivant la revendication 1, dans laquelle la teneur en B₂O₃ est 5 à 6 % en poids.

3. Composition de verre suivant la revendication 1, comprenant de plus du SrO, dans laquelle MgO + SrO constitue de 1 à 4 % en poids.

4. Composition de verre suivant la revendication 3, dans laquelle MgO + SrO est de 1 à 3 % en poids.

5. Composition de verre suivant la revendication 1, dans laquelle les constituants ont la relation suivante et les valeurs suivantes :
| | |
|---|---|
| RO = CaO + MgO + SrO | de 24,75 à 26,25 |
| RO/(SiO₂ + Al₂O₃) | de 0,30 à 0,45. |

6. Composition de verre suivant la revendication 1, dans laquelle les constituants ont les valeurs suivantes :
| | |
|---|---|
| (R₂O + RO + B₂O₃)/(SiO₂ + Al₂O₃) | de 0,45 à 0,50 |
où R₂O = % en poids de Na₂O + Li₂O + K₂O, lorsque présent dans le verre, et RO = CaO + MgO + SrO.

7. Composition de verre suivant la revendication 5, dans laquelle les constituants sont dans les % en poids suivants :
| | |
|---|---|
| SiO₂ | 52 à 54 % en poids |
| Al₂O₃ | 13 à 15 % en poids |
| CaO | 23 à 25 % en poids |
| MgO | 1 à 3 % en poids |
| SrO | 0 à 3 % en poids |
| MgO + SrO | 1 à 3 % en poids. |

8. Composition de verre suivant la revendication 7, comprenant de plus :
| | |
|---|---|
| Fer total | 0,05 à 0,8 % en poids |
| SO₃ | plus de 0 % en poids. |

9. Composition de verre suivant la revendication 4, dans laquelle les constituants comprennent :
| | |
|---|---|
| SiO₂ | 52,86 à 54,33 % en poids |
| B₂O₃ | 5,15 à 6,05 % en poids |
| Al₂O₃ | 13,44 à 14,14 % en poids |
| CaO | 23,42 à 24,16 % en poids |
| MgO | 1,17 à 1,5 % en poids |
| SrO | 0,12 à 0,15 % en poids |
| MgO + SrO | 1,29 à 1,65 % en poids. |

10. Composition de verre suivant la revendication 9, comprenant de plus :
| | |
|---|---|
| Fer total | 0,29 à 0,37 % en poids |
| SO₃ | plus de 0 % en poids |
| K₂O | 0,09 à 0,11 % en poids |
| TiO₂ | 0,54 à 0,62 % en poids |
| Na₂O | 0,41 à 0,91 % en poids |
| ZrO₂ | moins de 0,1 % en poids. |

11. Composition de verre suivant la revendication 10, dans laquelle les constituants ont les valeurs suivantes :
| | |
|---|---|
| Al₂O₃/SiO₂ | de 0,25 à 0,27 |
| RO = CaO + MgO + SrO | de 25,02 à 25,68 |
| RO/(SiO₂ + Al₂O₃) | de 0,37 à 0,38 |
| (R₂O + RO + B₂O₃)/(SiO₂ + Al₂O₃) | de 0,46 à 0,48, |
où R₂O = % en poids de Na₂O + Li₂O + K₂O.

12. Composition de verre suivant la revendication 1, dans laquelle la température de formation n'est pas supérieure à 1185°C.

13. Toile de fibres de verre tissée, dans laquelle au moins une des fibres de verre a la composition de la revendication 1.

14. Carte à circuit imprimé comprenant une toile de fibres de verre tissée, dans laquelle au moins une des fibres de verre a la composition de la revendication 1.
